# EUROPÄISCHE PATENTSCHRIFT

(11) **EP 2 423 750 B1**
(45) Veröffentlichungstag und Bekanntmachung des Hinweises auf die Patenterteilung: **26.12.2018**
(21) Anmeldenummer: 11178274.4
(22) Anmeldetag: 22.08.2011
(51) Int. Cl.: G03F 7/20

(54) **Beleuchtungseinheit und Vorrichtung zur lithografischen Belichtung**
Exposure unit and device for lithographic exposure
Unité d'éclairage et dispositif d'éclairage lithographique

(30) Priorität: 23.08.2010 DE 102010035111
(43) Veröffentlichungstag der Anmeldung: 29.02.2012
(73) Patentinhaber: Fraunhofer-Gesellschaft zur Förderung der angewandten Forschung e.V., 80686 München (DE)
(72) Erfinder: Zeitner, Uwe D., 99423 Weimar (DE); Harzendorf, Torsten, 07743 Jena (DE); Stürzebecher, Lorenz, 07745 Jena (DE)
(74) Vertreter: Epping - Hermann - Fischer

(56) Entgegenhaltungen:
- EP-A2- 1 914 583
- CN-A- 101 174 093
- DE-A1- 19 716 794
- US-A- 5 790 239
- US-A1- 2004 174 512
- US-A1- 2009 021 716

## Beschreibung

Die Erfindung betrifft eine Vorrichtung zur lithografischen Belichtung periodischer Strukturen mit einer Beleuchtungseinheit.

Diese Patentanmeldung beansprucht die Priorität der deutschen Patentanmeldung 10 2010 035 111.3.

Für die Erzeugung von deterministischen Mikrostrukturen werden häufig lithografische Verfahren eingesetzt. Dabei wird eine strahlungsempfindliche Polymerschicht (Resist) mit einer lateral variierenden Dosisverteilung einer bestimmten Strahlungsart belichtet. Bei der Strahlungsart kann es sich um Licht (Fotolithografie), Elektronen (Elektronenstrahllithografie), Röntgenstrahlung (Röntgenlithografie) oder andere Strahlungsarten handeln. Die eingebrachte Strahlungsdosis verändert die Polymereigenschaften in einer Weise, dass in einem anschließenden Entwicklungsschritt selektiv nur die bestrahlten (Positivresist) oder nur die unbestrahlten (Negativresist) Bereiche der Polymerschicht gelöst und damit entfernt werden.

Die laterale Auflösung der realisierbaren Strukturen ist stark abhängig von der verwendeten Strahlungsart und der Anordnung zur Erzeugung der lateralen Variation der Bestrahlungsdosis.

Eine der am weitesten verbreiteten lithografischen Technologien ist die Fotolithografie mit einem sogenannten Mask Aligner (Maskenpositionierer), also einer Vorrichtung zur exakten Positionierung von Fotomasken. Dabei wird das Licht einer möglichst kurzwelligen Lichtquelle, beispielsweise einer Quecksilber-Hochdrucklampe, mit Hilfe einer Beleuchtungsoptik gesammelt und zur Beleuchtung einer vorgefertigten Fotomaske eingesetzt. Diese Fotomaske enthält die in die strahlungsempfindliche Polymerschicht zu belichtenden Strukturen in Form von transparenten und nicht transparenten Bereichen, die z. B. in eine dünne Chromschicht auf einem Maskensubstrat eingebracht sind. In den transparenten Bereichen wird die Chromschicht dazu selektiv entfernt. Mit einer solchen Fotomaske wird das Beleuchtungslicht beim Durchtritt durch die Fotomaske entsprechend moduliert. Die zu belichtende Polymerschicht befindet sich auf einem Substrat, welches in direkten Kontakt mit der Fotomaske gebracht wird (so genanntes Contact Printing) oder sich in einem geringen Abstand von einigen Mikrometern zur Fotomaske befindet (so genanntes Proximity Printing).

Infolge der an der Maskenstruktur auftretenden Beugung des Beleuchtungslichts ist die Intensitätsverteilung hinter der Fotomaske nicht mehr scharf begrenzt, sondern verschmiert mit zunehmendem Abstand zwischen der Fotomaske und der strahlungsempfindlichen Polymerschicht. Dieser Effekt begrenzt die kleinste übertragbare Strukturgröße nach unten. Typischerweise erreicht man mit dieser Anordnung laterale Strukturgrößen von 0,5 µm beim Contact Printing bzw. von wenigen Mikrometern im Fall des Proximity Printing.

Eine Verbesserung der Auflösung ist durch eine deutlich aufwändigere Anordnung möglich, bei der die Maskenstruktur mit Hilfe einer Abbildungsoptik auf die strahlungsempfindliche Polymerschicht abgebildet wird. Dies wird z. B. in so genannten Steppern realisiert. Die hohen Anforderungen an die optische Leistung der erforderlichen Abbildungsoptik machen diese Systeme jedoch deutlich teurer als einen Mask Aligner. Aus diesem Grund sind Stepper wesentlich weniger stark verbreitet als Mask Aligner.

Aus der Druckschrift DE 19716794 A1 ist eine Vorrichtung zur lithografischen Belichtung bekannt, die eine Lichtquelle zur Abstrahlung eines Beleuchtungslichts, ein erstes doppelseitiges Linsenarray, eine erste Blende, eine dem ersten doppelseitigen Linsenarray nachfolgende erste Linse, ein zweites doppelseitiges Linsenarray, das in der Brennebene der ersten Linse angeordnet ist, eine zweite Blende und eine dem zweiten doppelseitigen Linsenarray nachfolgende zweite Linse aufweist. Mittels der Vorrichtung wird ein Werkstück durch eine Maske belichtet.

Eine Aufgabe der Erfindung besteht darin, eine Vorrichtung zur lithografischen Belichtung anzugeben, die zur Erzeugung periodischer Strukturen geeignet ist und sich durch eine verbesserte laterale Strukturauflösung auszeichnet.
Diese Aufgaben werden durch eine Vorrichtung zur lithografischen Belichtung gemäß dem unabhängigen Patentanspruch gelöst. Vorteilhafte Ausgestaltungen und Weiterbildungen der Erfindung sind Gegenstand der abhängigen Ansprüche.

Die Vorrichtung zur lithografischen Belichtung umfasst eine Beleuchtungseinheit mit einer Lichtquelle zur Abstrahlung eines Beleuchtungslichts. Als Lichtquelle kann beispielsweise eine Hg-Hochdrucklampe eingesetzt werden. Alternativ können aber auch andere Lichtquellen für die Beleuchtungseinheit verwendet werden, wobei die bei der lithografischen Belichtung erzielbare Auflösung umso besser ist, je geringer die Wellenlänge des von der Lichtquelle abgestrahlten Beleuchtungslichts ist.

Die Lichtquelle weist vorzugsweise eine Kollimationsoptik auf. Bei der Kollimationsoptik kann es sich beispielsweise um einen Reflektor handeln, in dem die Lichtquelle angeordnet ist.

Der Lichtquelle folgt im Strahlengang ein erstes doppelseitiges Linsen-Array nach. Unter einem doppelseitigen Linsen-Array wird hier und im Folgenden ein optisches Element verstanden, das sowohl auf seiner Vorderseite als auch auf seiner Rückseite eine Vielzahl von Mikrolinsen aufweist.

Die Mikrolinsen auf der Vorderseite und auf der Rückseite des doppelseitigen Linsen-Arrays sind vorteilhaft regelmäßig angeordnet, wobei jeder Mikrolinse auf der Vorderseite eine gleichartige Mikrolinse auf der Rückseite des doppelseitigen Linsen-Arrays zugeordnet ist. Der Abstand einer Mikrolinse auf der Vorderseite und der ihr zugeordneten Mikrolinse auf der Rückseite des doppelseitigen Linsen-Arrays ist vorzugsweise gleich dem Abstand der Brennweite der Mikrolinsen.

Das der Lichtquelle nachgeordnete erste doppelseitige Linsen-Array hat insbesondere den Zweck, die Intensitätsverteilung des von der Lichtquelle abgestrahlten Beleuchtungslichts in lateraler Richtung, also senkrecht zur Hauptstrahlrichtung, zu homogenisieren.

Weiterhin enthält die Beleuchtungseinheit mindestens eine dem ersten doppelseitigen Linsen-Array nachfolgende erste Linse. Bei der ersten Linse handelt es sich vorteilhaft um eine Sammellinse. Insbesondere hat die erste Linse den Zweck, das Beleuchtungslicht nach dem Durchtritt durch das erste doppelseitige Linsen-Array zu fokussieren. "Mindestens eine erste Linse" bedeutet, dass die erste Linse auch durch eine Linsenanordnung aus mehreren Linsen ersetzt werden kann, beispielsweise durch zwei hintereinander angeordnete Linsen gleicher Brennweite f, die im Abstand ihrer Brennweite angeordnet sind.

In der Brennebene der ersten Linse ist ein zweites doppelseitiges Linsen-Array angeordnet. Das zweite doppelseitige Linsen-Array entspricht hinsichtlich seiner vorteilhaften Ausgestaltungen dem ersten doppelseitigen Linsen-Array und kann insbesondere identisch zu dem ersten doppelseitigen Linsen-Array sein. Das zweite doppelseitige Linsen-Array hat insbesondere den Zweck, die Winkelverteilung des abgestrahlten Beleuchtungslichts zu homogenisieren.

Auf das zweite doppelseitige Linsen-Array folgt im Strahlengang mindestens eine zweite Linse, bei der es sich wie bei der ersten Linse vorteilhaft um eine Sammellinse handelt. "Mindestens eine zweite Linse" bedeutet, dass die zweite Linse auch durch eine Linsenanordnung aus mehreren Linsen ersetzt werden kann, beispielsweise durch zwei hintereinander angeordnete Linsen gleicher Brennweite f, die im Abstand ihrer Brennweite angeordnet sind.

Weiterhin umfasst die Beleuchtungseinheit eine Blende. Die Blende ist vorzugsweise im Strahlengang unmittelbar vor oder nach dem zweiten doppelseitigen Linsen-Array angeordnet, also insbesondere zwischen der ersten Linse und dem zweiten doppelseitigen Linsen-Array oder zwischen dem zweiten doppelseitigen Linsen-Array und der zweiten Linse.

Durch die in der Beleuchtungseinheit angeordnete Anordnung aus dem ersten doppelseitigen Linsen-Array und dem zweiten doppelseitigen Linsen-Array werden vorteilhaft sowohl die räumliche Intensitätsverteilung als auch die Winkelverteilung des Beleuchtungslichts homogenisiert. Das erste und das zweite doppelseitige Linsen-Array sind dazu vorteilhaft in zwei zueinander konjugierten Ebenen im Strahlengang angeordnet. Konjugierte Ebenen zeichnen sich dadurch aus, dass sie durch eine optische Fouriertransformation miteinander verbunden sind. Solche konjugierten Ebenen sind z. B. die vordere und die hintere Brennebene einer Linse. Bei der Beleuchtungseinheit ist vorzugsweise das erste doppelseitige Linsen-Array in der der Lichtquelle zugewandten Brennebene der ersten Linse und das zweite doppelseitige Linsen-Array in der von der Lichtquelle abgewandten Brennebene der ersten Linse angeordnet.

Wie die erste Linse weist auch die zweite Linse zwei zueinander konjugierte Ebenen auf. In der der Lichtquelle zugewandten konjugierten Ebene befindet sich vorzugsweise das zweite doppelseitige Linsen-Array. In der von der Lichtquelle abgewandten konjugierten Ebene der zweiten Linse sind vorteilhaft sowohl die laterale Intensitätsverteilung als auch die Winkelverteilung des Beleuchtungslichts homogenisiert. Diese der zweiten Linse im Strahlengang nachfolgende konjugierte Ebene kann insbesondere als Maskenebene einer lithografischen Vorrichtung dienen, d. h. dort kann eine zur lithografischen Belichtung vorgesehene Fotomaske angeordnet werden.

Die Vorrichtung zur lithografischen Belichtung umfasst die zuvor beschriebene Beleuchtungseinheit, eine Fotomaske, die eine periodische Maskenstruktur aufweist, und ein mit einer strahlungsempfindlichen Polymerschicht beschichtetes Substrat.

Die hierin beschriebene Vorrichtung macht sich unter anderem den nach ihrem Entdecker benannten Talbot-Effekt zunutze. Beleuchtet man eine periodische Struktur mit kollimiertem Licht einer bestimmten Wellenlänge oder eines engen Wellenlängenspektrums, so erzeugt die Beugung an der periodischen Struktur in bestimmten, wiederkehrenden Abständen L hinter der Struktur ein Interferenzmuster, welches im Wesentlichen mit der periodischen Struktur übereinstimmt. Diese so genannten Talbot-Distanzen L sind gegeben durch die Gleichung L = 2*m*p²/λ.

Dabei ist m eine ganze Zahl, p die Periode der periodischen Maskenstruktur und λ die Wellenlänge des Beleuchtungslichts. In ungeradzahligen Vielfachen des Abstands L/2 findet man ein ähnliches Interferenzmuster, welches jedoch in lateraler Richtung um p/2 verschoben ist.

Die Ausnutzung des Talbot-Effekts setzt die Beleuchtung der Fotomaske mit einem hinsichtlich der Intensitätsverteilung und der Winkelverteilung homogenen Beleuchtungslicht voraus. Insbesondere soll die Beleuchtung über die gesamte Fläche der Fotomaske möglichst homogen sein. Eine derart homogene Beleuchtung ist bei herkömmlichen lithografischen Verfahren, insbesondere bei einem herkömmlichen Mask Aligner, in der Regel nicht gegeben.

Bei der hierin beschriebenen Vorrichtung zur lithografischen Belichtung wird die Ausnutzung des Talbot-Effekts durch die zuvor beschriebene Beleuchtungseinheit ermöglicht, die am Ort der Fotomaske eine hinsichtlich der Intensitätsverteilung und der Winkelverteilung homogene Beleuchtung erzeugt.

Bei der Vorrichtung sind die Fotomaske und die strahlungsempfindliche Polymerschicht derart angeordnet, dass ihr Abstand gleich der Talbot-Länge L = 2*m*p²/λ ist.

Da der Talbot-Effekt von der Wellenlänge λ abhängig ist, weist die Beleuchtungseinheit vorzugsweise einen Wellenlängenfilter auf, der als Monochromator für das Beleuchtungslicht dient. Der Wellenlängenfilter ist vorzugsweise ein Interferenzfilter.

Damit der Abstand L möglichst über die gesamte Fläche der strahlungsempfindlichen Polymerschicht eingehalten werden kann, ist es erforderlich, die strahlungsempfindliche Polymerschicht so parallel wie möglich zur Ebene des Interferenzmusters auszurichten. Um eine Verkippung der strahlungsempfindlichen Polymerschicht gegenüber der Ebene des Interferenzmusters zu vermeiden, ist es vorteilhaft, wenn die Vorrichtung einen besonders ebenen Substrathalter zur Aufnahme des Substrats mit der strahlungsempfindlichen Polymerschicht aufweist. Vorzugsweise ist der Substrathalter derart eben, dass über die Fläche des Substrathalters keine Höhendifferenzen von mehr als 500 nm auftreten.

Weiterhin ist ein Abstand zwischen der Fotomaske und dem mit der strahlungsempfindlichen Polymerschicht beschichteten Substrat vorzugsweise mit einer Genauigkeit von besser als 500 nm einstellbar. Hierzu kann beispielsweise der Substrathalter eine geeignete Justagevorrichtung aufweisen, sodass das mit der strahlungsempfindlichen Polymerschicht beschichtete Substrat mit einer derartigen Genauigkeit in Richtung zur Fotomaske hin positioniert werden kann. Insbesondere kann zur Einstellung des Abstands zwischen dem Substrat und der Fotomaske eine interferometrisch-optische Entfernungsmessung eingesetzt werden.

Die hierin beschriebene Vorrichtung ermöglicht es zum einen, die periodische Maskenstruktur unter einer Ausnutzung des Talbot-Effekts durch eine Belichtung mittels der Beleuchtungseinheit in die strahlungsempfindliche Polymerschicht zu übertragen. Damit am Ort der strahlungsempfindlichen Polymerschicht, die in dem Talbot-Abstand L zur Fotomaske angeordnet ist, ein Interferenzmuster auftritt, welches einer Selbstabbildung der Maskenstruktur entspricht, ist es erforderlich, dass das Beleuchtungslicht am Ort der Fotomaske weitestgehend dem theoretischen Idealfall einer ebenen Welle entspricht. In diesem Fall trifft das Beleuchtungslicht zumindest nahezu senkrecht auf die Fotomaske.

Es hat sich herausgestellt, dass dies dadurch erzielt werden kann, dass als Blende der Beleuchtungseinheit eine Lochblende eingesetzt wird. Die Lochblende weist vorzugsweise eine möglichst kleine Öffnung auf.

Bevorzugt weist die Blende eine Öffnung mit einem Durchmesser von weniger als 5 mm auf.

Durch eine derartige Lochblende wird die Winkelverteilung des Beleuchtungslichts vorteilhaft derart eingeschränkt, dass das Beleuchtungslicht nahezu senkrecht auf die Fotomaske auftrifft und somit der Talbot-Effekt für die lithografische Belichtung nutzbar wird.

Bei einer anderen Ausgestaltung der Vorrichtung wird eine Blende eingesetzt, die in ihrer Form und/oder Größe derart ausgeführt ist, dass das auf die Fotomaske auftreffende Beleuchtungslicht nicht als ebene Welle betrachtet werden kann. In diesem Fall wird die Fotomaske also mit einer Winkelverteilung beleuchtet.

Bei dieser Anordnung kann jede Komponente der Winkelverteilung einzeln als ebene Welle mit einem entsprechenden Einfallswinkel auf die Fotomaske betrachtet werden. Eine einzelne, senkrecht auf die Fotomaske einfallende ebene Welle erzeugt entsprechend des Talbot-Effekts in dem Talbot-Abstand L die oben beschriebene Selbstabbildung der Maskenstruktur. Eine unter einem Winkel α auf die Fotomaske einfallende Welle erzeugt ebenfalls die Selbstabbildung in dem Talbot-Abstand L, allerdings ist diese in lateraler Richtung um eine Distanz Δx = L*tan(α) gegenüber der bei senkrechtem Lichteinfall entstehenden Selbstabbildung verschoben.

Auf diese Weise lassen sich periodische Strukturen herstellen, deren Periode gleich der Periode der Fotomaske ist, wobei aber die Geometrie der in die strahlungsempfindliche Polymerschicht belichteten Struktur durch die Winkelverteilung des Beleuchtungslichts beeinflusst wird und somit durch die makroskopische Struktur der Blende der Beleuchtungseinheit definiert werden kann. Insbesondere kann bei dieser Ausgestaltung eine Blende verwendet werden, die eine von einer Lochblende abweichende Form aufweist.

Bei der Vorrichtung wird eine Blende verwendet, die innerhalb der Blendenöffnung eine örtlich variierende Transmission aufweist. Auf diese Weise ist es möglich, eine kontinuierliche Lichtverteilung in der strahlungsempfindlichen Polymerschicht zu erzeugen. Dies ermöglicht die lithografische Herstellung periodischer Strukturen mit kontinuierlichen Oberflächenprofilen, bei denen sich das Höhenprofil über die Winkelverteilung der Beleuchtung, die durch die Transmission der Blende eingestellt wird, steuern lässt.

Mittels der Vorrichtung wird vorteilhaft eine besonders gute laterale Strukturauflösung erzielt. Insbesondere kann die periodische Maskenstruktur Strukturbreiten von weniger als 1 µm aufweisen. Bevorzugt betragen die Strukturbreiten weniger als 500 nm und besonders bevorzugt sogar weniger als 250 nm. Insbesondere hat sich herausgestellt, dass mittels der Vorrichtung eine laterale Strukturauflösung im Bereich der verwendeten Wellenlänge (z.B. 365 nm bei Verwendung einer Hg-Hochdrucklampe) erzielt werden kann. Auf diese Weise kann die Auflösung eines herkömmlichen Mask Aligners um etwa einen Faktor 2,5 für das Contact Printing oder für das Proximity Printing um mehr als den Faktor 10 übertroffen werden.

Ein weiterer Vorteil der Vorrichtung besteht darin, dass zum Erreichen der hohen lateralen Strukturauflösung die Fotomaske bei dem Belichtungsprozess nicht in direkten Kontakt mit der zu belichtenden strahlungsempfindlichen Polymerschicht kommt, da das zur Belichtung genutzte Interferenzmuster erst in dem Abstand L hinter der Fotomaske auftritt. Auf diese Weise wird das Risiko von Defekten auf der Fotomaske infolge eines direkten Kontakts mit der strahlungsempfindlichen Polymerschicht wesentlich verringert, was insbesondere in Produktionsprozessen deutliche Vorteile beinhaltet.

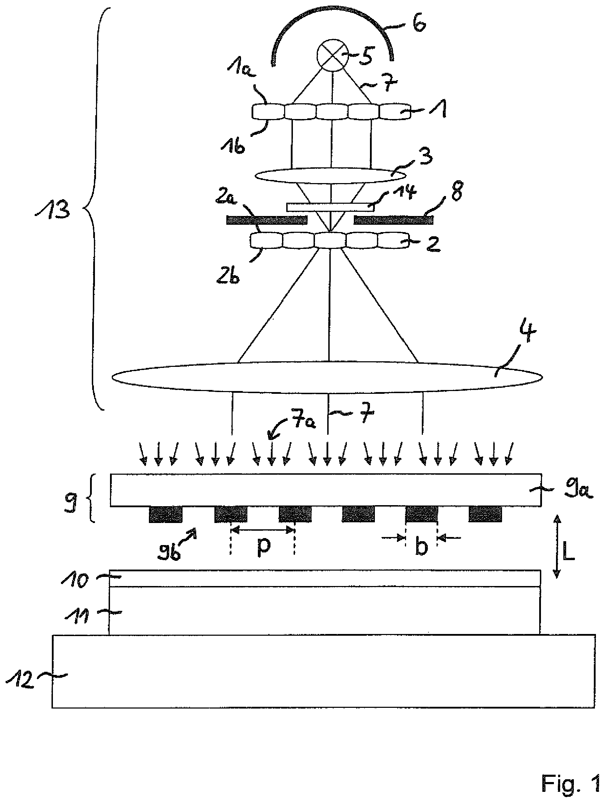

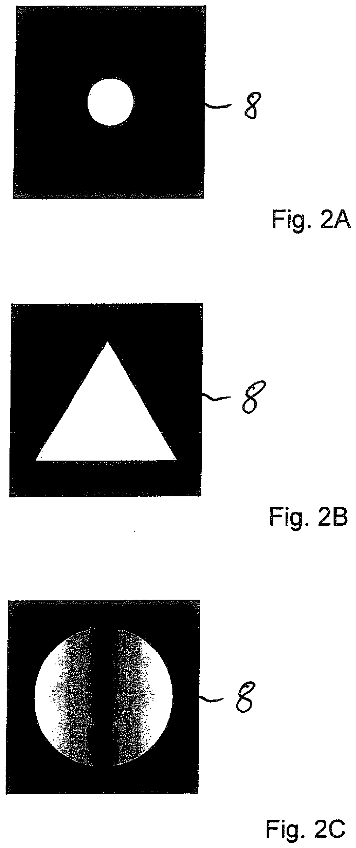

Die Erfindung wird im Folgenden anhand von Ausführungsbeispielen im Zusammenhang mit den Figuren 1 und 2 näher erläutert.

Es zeigen:
Figur 1 eine schematische Darstellung eines Querschnitts durch eine Vorrichtung zur lithografischen Belichtung gemäß einem Ausführungsbeispiel, und
Figuren 2A bis 2C schematische Darstellungen von zwei nicht erfindungsgemäßen Beispielen der Blende der Beleuchtungseinheit (Figuren 2A und 2B) und eines erfindungsgemäßen Ausführungsbeispiels der Blende (Figur 2C).

Die in den Figuren dargestellten Bestandteile sowie die Größenverhältnisse der Bestandteile untereinander sind nicht als maßstabsgerecht anzusehen.

Die in Figur 1 dargestellte Vorrichtung zur lithografischen Belichtung enthält eine Beleuchtungseinheit 13, die dazu eingerichtet ist, eine Fotomaske 9 mit einem Beleuchtungslicht 7 zu beleuchten, um eine periodische Struktur 9b der Fotomaske 9 eine strahlungsempfindliche Polymerschicht 10 abzubilden.

Die Vorrichtung macht sich den so genannten Talbot-Effekt zunutze. Gemäß diesem nach ihrem Entdecker H. F. Talbot benannten Beugungseffekt erzeugt die Beugung an einer periodischen Struktur bei einer Beleuchtung mit kollimiertem Licht einer bestimmten Wellenlänge λ in bestimmten, wiederkehrenden Abständen hinter der Struktur ein Interferenzmuster, welches im Wesentlichen mit der periodischen Struktur übereinstimmt. Diese so genannten Talbot-Distanzen L sind durch die Gleichung L = 2*m*p2/λ gegeben, wobei m eine ganze Zahl ist, p die Periode der Struktur und λ die Beleuchtungswellenlänge.

Um den Talbot-Effekt auszunutzen, weist die Fotomaske 9 der Vorrichtung eine periodische Maskenstruktur 9b auf. Die periodische Struktur 9b kann beispielsweise durch eine strukturierte Schicht gebildet sein, die auf ein transparentes Maskensubstrat 9a aufgebracht sein kann. Die periodische Struktur 9b kann die Amplitude (Amplitudenstruktur) und/oder die Phase (Phasenstruktur) des transmittierten Beleuchtungslichts 7 beeinflussen. Die Amplituden- oder Phasenstruktur oder eine Kombination aus beiden kann eine beliebige Form aufweisen, die sich mit der Periode p ein- oder zweidimensional fortsetzt, zum Beispiel hexagonal-periodisch. Eine Amplitudenstruktur kann z. B. dadurch realisiert sein, dass eine strukturierte Metallschicht wie beispielsweise eine strukturierte Chromschicht auf ein transparentes Maskensubstrat 9a aufgebracht ist, welche das Licht ganz oder zumindest teilweise absorbiert.

In einem Abstand L zu der periodischen Maskenstruktur 9b, der die zuvor genannte Gleichung für die Talbot-Distanzen erfüllt, ist eine strahlungsempfindliche Polymerschicht 10 angeordnet. Die strahlungsempfindliche Polymerschicht 10 kann auf ein Substrat 11 aufgebracht sein, das in der Vorrichtung von einem Substrathalter 12 gehalten wird.

Um die periodische Maskenstruktur 9b und die strahlungsempfindliche Polymerschicht 10 in eine Talbot-Distanz L zueinander zu bringen, ist der Abstand zwischen der Fotomaske 9 und dem mit der strahlungsempfindlichen Polymerschicht 10 beschichteten Substrat 11 vorzugsweise mit einer Genauigkeit von besser als 500 nm einstellbar. Hierzu weisen der Substrathalter 12 und/oder die Fotomaske 9 eine dazu geeignete Justagevorrichtung, insbesondere eine auf einer optischen Distanzmessung basierende Justagevorrichtung, auf.

Weiterhin ist es von Vorteil, wenn der Substrathalter 12 derart eben ist, dass über die dem Substrat 11 zugewandte Oberfläche des Substrathalters 12 keine Höhendifferenzen von mehr als 500 nm auftreten. Auf diese Weise wird insbesondere eine Abstandsvariation der strahlungsempfindlichen Polymerschicht 10 gegenüber der Fotomaske 9 verhindert. Weiterhin sollte auch das Substrat 11 zumindest derart eben sein, dass keine Höhendifferenzen von mehr als 500 nm auftreten.

Der Vorteil der Ausnutzung des Talbot-Effekts liegt zum einen darin, dass bei dieser beugungsunterstützten Lithografie hohe laterale Strukturauflösungen erzielt werden können. Die periodische Maskenstruktur 9b kann insbesondere eine Strukturbreite b von weniger als 1 µm aufweisen. Bevorzugt beträgt die Strukturbreite b weniger als 500 nm, besonders bevorzugt sogar weniger als 200 nm.

Ein weiterer Vorteil der beschriebenen Vorrichtung besteht darin, dass die Fotomaske 9 nicht in direkten Kontakt mit der strahlungsempfindlichen Polymerschicht 10 gebracht wird. Auf diese Weise wird das Risiko von Defekten auf der Fotomaske 9 infolge eines direkten Kontakts wesentlich verringert.

Die mit der Vorrichtung erzielbare laterale Auflösung ist aus physikalischen Gründen mit einer Reduktion der Schärfentiefe verbunden. Ein allgemeiner Zusammenhang zwischen lateraler Auflösung Δs und Schärfentiefe Δz ist durch die Gleichung Δz = k*Δs²/λ gegeben, wobei k ein geometrieabhängiger Faktor ist. Auch aus diesem Grund sind an die Genauigkeit, mit welcher der Abstand zwischen der Fotomaske 9 und dem mit der strahlungsempfindlichen Polymerschicht 10 beschichteten Substrat 11 eingestellt werden kann, besondere Anforderungen zu stellen, wobei der Abstand vorzugsweise mit einer Genauigkeit von besser als 500 nm einstellbar ist.

Die Ausnutzung des Talbot-Effekts in der Vorrichtung erfordert, dass die Fotomaske 9 mit einem Beleuchtungslicht 7 beleuchtet wird, das über die Fläche der Fotomaske 9 eine möglichst homogene Intensitätsverteilung und Winkelverteilung aufweist. Die benötigte Intensitäts- und Winkelverteilung wird bei der Vorrichtung durch eine spezielle Beleuchtungseinheit 13 erzielt.

Die Beleuchtungseinheit 13 weist eine Lichtquelle 5 auf, die das Beleuchtungslicht 7 abstrahlt. Die Lichtquelle 5 kann zum Beispiel eine Hg-Hochdrucklampe sein. Alternativ kann die Beleuchtungseinheit 13 aber auch eine andere Lichtquelle 5 aufweisen. Die Lichtquelle 5 kann z. B. in einem Reflektor 6 angeordnet sein, wobei der Reflektor 6 als Kollimationsoptik dient.

Um sowohl die räumliche Intensitätsverteilung als auch die Winkelverteilung 7a des Beleuchtungslichts 7 zu homogenisieren, werden in der Beleuchtungseinheit 13 insbesondere zwei doppelseitige Linsen-Arrays 1, 2 eingesetzt, die vorteilhaft in zwei zueinander konjugierten Ebenen im Beleuchtungsstrahlengang angeordnet sind. Konjugierte Ebenen zeichnen sich dadurch aus, dass sie durch eine optische Fourier-Transformation miteinander verbunden sind.

Die doppelseitigen Linsen-Arrays 1, 2 weisen vorzugsweise eine regelmäßige Anordnung von Mikrolinsen 1a, 2a auf der Vorderseite und eine entsprechende regelmäßige Anordnung von Mikrolinsen 1b, 2b auf der Rückseite auf. Insbesondere ist jeder vorderseitigen Mikrolinse 1a, 2a jeweils eine rückseitige Mikrolinse 1b, 2b zugeordnet, die in Richtung der optischen Achse im Abstand der einfachen Brennweite der Mikrolinsen 1a, 1b, 2a, 2b angeordnet sind.

Durch die Anordnung des ersten doppelseitigen Linsen-Arrays 1 im Strahlengang der Beleuchtungseinheit 13 lässt sich die Intensitätsverteilung in der zur Ebene dieses Linsen-Arrays 1 konjugierten Ebene räumlich homogenisieren. Diese konjugierte Ebene befindet sich in der dem ersten Linsen-Array 1 abgewandten Brennebene einer Linse 3. In dieser konjugierten Ebene ist das zweite doppelseitige Linsen-Array 2 angeordnet, durch das auch die Winkelverteilung des Beleuchtungslichts 7 homogenisiert wird.

Die Ebene des zweiten doppelseitigen Linsen-Arrays 2 wird wiederum durch eine weitere Linse 4 zu einer zur Ebene der Fotomaske 9 konjugierten Ebene. Auf diese Weise wird erreicht, dass in der Ebene der Fotomaske 9 sowohl die laterale Intensitätsverteilung als auch die Winkelverteilung des Beleuchtungslichts 7 homogenisiert sind. Die Winkelverteilung des Beleuchtungslichts 7 wird in der Figur 1 durch die Pfeile 7a symbolisiert.

Die Beleuchtungseinheit enthält im Strahlgang zwischen der Lichtquelle 5 und der Fotomaske 9 vorteilhaft einen Wellenlängenfilter 14, der als Monochromator für das Beleuchtungslicht fungiert. Insbesondere kann der Wellenlängenfilter 14 ein Interferenzfilter sein.

Ohne weitere Maßnahmen ist die Winkelverteilung 7a des Beleuchtungslichts 7 noch derart breit, dass das auf die Fotomaske 9 auftreffende Beleuchtungslicht 7 nicht als ebene Welle betrachtet werden kann. Vielmehr kann jede Komponente der Winkelverteilung einzeln als ebene Welle mit einem entsprechenden Einfallswinkel auf die Fotomaske 9 betrachtet werden. Eine einzelne, senkrecht auf die Fotomaske 9 einfallende ebene Welle erzeugt entsprechend des Talbot-Effekts in der Talbot-Distanz L eine Selbstabbildung der periodischen Maskenstruktur 9b. Eine unter einem Winkel α auf die Fotomaske einfallende Welle erzeugt ebenfalls die Selbstabbildung der periodischen Maskenstruktur 9b in der Talbot-Distanz L, allerdings ist diese lateral um den Betrag Δx = L*tan(α) gegenüber der bei senkrechtem Lichteinfall entstehenden Selbstabbildung verschoben.

Dieser Effekt ermöglicht in der Vorrichtung durch die spezielle Beleuchtungseinheit 13 die Erzeugung von beliebigen periodischen Strukturen mit einer festen Fotomaske 9. Dazu wird vor oder hinter dem zweiten doppelseitigen Linsen-Array 2 eine Blende 8 in dem Strahlengang angeordnet. Mittels der Blende 8 kann die Winkelverteilung 7a des Beleuchtungslichts 7 gezielt beeinflusst und gesteuert werden. Jede Komponente der Winkelverteilung 7a erzeugt in der Talbot-Distanz L ein lateral verschobenes Selbstabbild der periodischen Maskenstruktur 9b. Bei kleinen periodischen Maskenstrukturen 9b lässt sich so die laterale Struktur der Blende 8 stark verkleinert und periodisch wiederholt auf die strahlungsempfindliche Polymerschicht 10 abbilden. In die strahlungsempfindliche Polymerschicht 10 wird also eine periodische Struktur abgebildet, deren Einheitszelle durch einen Austausch der Blende 8 geändert werden kann. Diese Ausgestaltung erzeugt insbesondere eine verkleinerte Abbildung der Blende 8, welche die Winkelverteilung 7a des Beleuchtungslichts 7 definiert, in die strahlungsempfindliche Polymerschicht 10. Die Blende 8 kann eine beispielsweise eine dreieckige Blendenöffnung aufweisen, wie es in Fig. 2B dargestellt ist. Es sind aber auch beliebige andere Formen von Blenden 8 möglich.

Bei der erfindungsgemäßen Vorrichtung weist die Blende 8 eine örtlich variable Transmission auf. Beispielsweise kann die Blende 8 eine ortsabhängige Absorption aufweisen, wobei sie z. B. örtlich variierende Grauwerte aufweist. Ein Beispiel für eine solche Blende 8 ist in Fig. 2C dargestellt. Auf diese Weise können kontinuierliche Lichtverteilungen in der strahlungsempfindlichen Polymerschicht 10 realisiert werden. Dies ermöglicht es insbesondere, periodische Strukturen mit kontinuierlichen Oberflächenprofilen lithografisch herzustellen, bei denen sich das Höhenprofil über die Winkelverteilung 7a des Beleuchtungslichts 7, d. h. durch die Transmission der Blende 8, steuern lässt.

Die Vorrichtung kann darüber hinaus auch zur direkten Erzeugung von periodischen Strukturen mittels des Talbot-Effekts genutzt werden. Bei dieser Ausgestaltung wird als Blende 8 eine Lochblende eingesetzt, wie sie zum Beispiel in Fig. 2A dargstellt ist. Die Blende 8 weist eine Öffnung auf, welche die Winkelverteilung 7a des Beleuchtungslichts 7 derart einschränkt, dass eine nahezu senkrechte Beleuchtung der Fotomaske 9 erfolgt. Damit entsteht in der Talbot-Distanz L eine Selbstabbildung der periodischen Maskenstruktur 9b. Die Blende 8 weist bei dieser Ausgestaltung vorzugsweise eine Öffnung mit einem Durchmesser von weniger als 5 mm auf.
Die Erfindung ist nicht durch die Beschreibung anhand der Ausführungsbeispiele beschränkt. Die Erfindung wird durch die Ansprüche definiert.

## Patentansprüche

1. Vorrichtung zur lithografischen Belichtung mit einer Beleuchtungseinheit (13), umfassend:
- eine Lichtquelle (5) zur Abstrahlung eines Beleuchtungslichts (7),
- ein erstes doppelseitiges Linsenarray (1),
- mindestens eine dem ersten doppelseitigen Linsenarray (1) nachfolgende erste Linse (3),
- eine Blende (8),
- ein zweites doppelseitiges Linsenarray (2), das in der Brennebene der ersten Linse (3) angeordnet ist, und
- mindestens eine dem zweiten doppelseitigen Linsenarray (2) nachfolgende zweite Linse (4),
- eine Fotomaske (9), die eine periodische Maskenstruktur (9b) aufweist, und
- ein mit einer strahlungsempfindlichen Polymerschicht (10) beschichtetes Substrat (11),
**dadurch gekennzeichnet, dass**
ein Abstand L zwischen der Fotomaske (9) und der strahlungsempfindlichen Polymerschicht (10) durch die Beziehung L = 2*m*p²/λ gegeben ist, wobei m eine ganze Zahl, p die Periode der periodischen Maskenstruktur (9b) und λ die Wellenlänge des Beleuchtungslichts (7) ist, und die Blende (8) eine Blendenöffnung mit einer örtlich variierenden Transmission aufweist.

2. Vorrichtung nach Anspruch 1,
die einen Wellenlängenfilter (14) enthält.

3. Vorrichtung nach einem der Ansprüche 1 oder 2,
die einen Substrathalter (12) zur Aufnahme des Substrats (11) umfasst.

4. Vorrichtung nach Anspruch 3,
wobei der Substrathalter (12) derart eben ist, dass über die Fläche des Substrathalters (12) keine Höhendifferenzen von mehr als 500 nm auftreten.

5. Vorrichtung nach einem der vorhergehenden Ansprüche,
wobei ein Abstand zwischen der Fotomaske (9) und dem mit der strahlungsempfindlichen Polymerschicht (10) beschichteten Substrat (11) mit einer Genauigkeit von besser als 500 nm einstellbar ist.

6. Vorrichtung nach einem der vorhergehenden Ansprüche,
wobei die Blende (8) der Beleuchtungseinheit (13) eine Lochblende ist.

7. Vorrichtung nach Anspruch 6,
wobei die Blende (8) eine Blendenöffnung von weniger als 5 mm aufweist.

8. Vorrichtung nach einem der vorhergehenden Ansprüche, wobei die Blende (8) eine von einer Lochblende abweichende Form aufweist.

9. Vorrichtung nach einem der vorhergehenden Ansprüche, wobei die periodische Maskenstruktur (9b) eine Amplitudenstruktur und/oder eine Phasenstruktur ist.

10. Vorrichtung nach einem der vorhergehenden Ansprüche, wobei die periodische Maskenstruktur (9b) Strukturbreiten von weniger als 1 µm aufweist.

11. Vorrichtung nach Anspruch 10,
wobei die periodische Maskenstruktur (9b) Strukturbreiten von weniger als 250 nm aufweist.

## Claims

1. Apparatus for lithographic exposure with an illumination unit (13), comprising:
- a light source (5) for emitting illuminating light (7),
- a first double-sided lens array (1),
- at least one first lens (3) downstream of the first double-sided lens array (1),
- an aperture (8),
- a second double-sided lens array (2), which is arranged in the focal plane of the first lens (3), and
- at least one second lens (4) downstream of the second double-sided lens array (2),
- a photomask (9), which has a periodic mask structure (9b), and
- substrate (11) coated with a radiation-sensitive polymer layer (10),
**characterized in that**
a spacing L between the photomask (9) and the radiation-sensitive polymer layer (10) is determined by the relationship L = 2*m*p²/λ, wherein m is an integer, p the period of the periodic mask structure (9b) and λ the wavelength of the illuminating light (7), and the aperture (8) has an aperture opening with locally varying transmittance.

2. Apparatus according to claim 1,
which includes a wavelength filter (14).

3. Apparatus according to one of claims 1 or 2,
which comprises a substrate holder (12) for accommodating the substrate (11).

4. Apparatus according to claim 3,
wherein the substrate holder (12) is planar, such that no differences in height of more than 500 nm occur over the surface of the substrate holder (12).

5. Apparatus according to one of the preceding claims,
wherein the spacing between the photomask (9) and the substrate (11) coated with the radiation-sensitive polymer layer (10) may be established with an accuracy of greater than 500 nm.

6. Apparatus according to one of the preceding claims,
wherein the aperture (8) of the illumination unit (13) is a pinhole aperture.

7. Apparatus according to claim 6,
wherein the aperture (8) has an aperture opening of less than 5 mm.

8. Apparatus according to one of the preceding claims,
wherein the aperture (8) has a shape other than a pinhole aperture.

9. Apparatus according to one of the preceding claims,
wherein the periodic mask structure (9b) is an amplitude structure and/or a phase structure.

10. Apparatus according to one of the preceding claims,
wherein the periodic mask structure (9b) has structure widths of less than 1 µm.

11. Apparatus according to claim 10,
wherein the periodic mask structure (9b) has structure widths of less than 250 nm.

## Revendications

1. Appareil pour une exposition lithographique avec une unité d'éclairage (13), comprenant :
- une source de lumière (5) pour émettre une lumière d'éclairage (7),
- un premier réseau de lentilles double face (1),
- au moins une première lentille (3) en aval du premier réseau de lentilles double face (1),
- un diaphragme (8),
- un second réseau de lentilles double face (2), qui est disposé dans le plan focal de la première lentille (3), et
- au moins une seconde lentille (4) en aval du second réseau de lentilles double face (2),
- un photomasque (9), qui a une structure de masque périodique (9b), et
- un substrat (11) revêtu d'une couche de polymère sensible à un rayonnement (10),
**caractérisé en ce que**
un espacement L entre le photomasque (9) et la couche de polymère sensible à un rayonnement (10) est déterminé par la relation L = 2*m*p²/λ, où m est un nombre entier, p la période de la structure de masque périodique (9b) et λ la longueur d'onde de la lumière d'éclairage (7), et le diaphragme (8) a une ouverture de diaphragme avec une transmittance variable localement.

2. Appareil selon la revendication 1,
qui comprend un filtre de longueur d'onde (14).

3. Appareil selon l'une des revendications 1 ou 2,
qui comprend un support de substrat (12) destiné à recevoir le substrat (11).

4. Appareil selon la revendication 3,
dans lequel le support de substrat (12) est plan, de telle sorte qu'aucune différence de hauteur de plus de 500 nm ne se produise sur la surface du support de substrat (12).

5. Appareil selon l'une des revendications précédentes,
dans lequel l'espacement entre le photomasque (9) et le substrat (11) revêtu de la couche de polymère sensible à un rayonnement (10) peut être établi avec une précision supérieure à 500 nm.

6. Appareil selon l'une des revendications précédentes,
dans lequel le diaphragme (8) de l'unité d'éclairage (13) est un diaphragme sténopéique.

7. Appareil selon la revendication 6,
dans lequel le diaphragme (8) a une ouverture de diaphragme inférieure à 5 mm.

8. Appareil selon l'une des revendications précédentes,
dans lequel le diaphragme (8) a une forme autre qu'un diaphragme sténopéique.

9. Appareil selon l'une des revendications précédentes,
dans lequel la structure de masque périodique (9b) est une structure à amplitude et/ou une structure à phase.

10. Appareil selon l'une des revendications précédentes,
dans lequel la structure de masque périodique (9b) a des largeurs de structure inférieures à 1 µm.

11. Appareil selon la revendication 10,
dans lequel la structure de masque périodique (9b) a des largeurs de structure inférieures à 250 nm.
